# EUROPEAN PATENT SPECIFICATION

(11) **EP 3 675 155 B1**
(45) Date of publication and mention of the grant of the patent: **30.09.2026**
(21) Application number: 18848552.8
(22) Date of filing: 08.08.2018
(51) Int. Cl.: C30B 13/10, C30B 29/06, C30B 33/02, C30B 33/04, H10P 34/40, H10P 36/00

(54) **RECOMBINATION LIFETIME CONTROL METHOD**
VERFAHREN ZUR STEUERUNG DER REKOMBINATIONSLEBENSDAUER
PROCÉDÉ DE CONTRÔLE DE DURÉE DE VIE DE RECOMBINAISON

(30) Priority: 22.08.2017 JP 2017159798
(43) Date of publication of application: 01.07.2020
(73) Proprietor: Shin-Etsu Handotai Co., Ltd., Tokyo 100-0004 (JP)
(72) Inventor: TAKENO, Hiroshi, Annaka-shi Gunma 379-0196 (JP)
(74) Representative: Wibbelmann, Jobst
(86) International application number: PCT/JP2018/029697
(87) International publication number: WO 2019/039273

(56) References cited:
- EP-A1- 1 811 065
- WO-A1-2007/055352
- WO-A1-2013/100155
- JP-A- 2002 110 687
- JP-A- 2009 249 262
- JP-A- 2015 198 166
- JP-A- 2015 198 166
- GRANT NICHOLAS E. ET AL: "Thermal activation and deactivation of grown-in defects limiting the lifetime of float-zone silicon", PHYSICA STATUS SOLIDI. RAPID RESEARCH LETTERS, vol. 10, no. 6, 1 June 2016 (2016-06-01), DE, pages 443 - 447, XP055780899, ISSN: 1862-6254, DOI: 10.1002/pssr.201600080

## Description

### TECHNICAL FIELD

The present invention relates to a method for controlling a recombination lifetime of carriers in a silicon substrate.

### BACKGROUND ART

In power devices such as an insulated gate bipolar transistor (Insulated Gate Bipolar Transistor: IGBT) or a diode, there has been conventionally adopted a technology which intentionally introduces a defect which becomes a recombination center of carriers into a silicon substrate and controls a recombination lifetime of the carriers to be shortened, thereby increases a switching speed, and consequently reduces switching loss.

As methods for controlling the recombination lifetime, there are a method for diffusing heavy metal impurities such as gold or platinum into a substrate and a method for applying charged particle beams (which may be referred to particle beams) of electron beams, protons, or helium ions or the like. In the method for diffusing heavy metal impurities, since control over concentration, a distribution in a depth direction, or radial uniformity is difficult, charged particle beam irradiation has been often used in recent years (see Patent Document 1, Patent Document 2, and Patent Document 3). In case of applying the charged particle beams, since a plurality of types of defects which become recombination centers are introduced near room temperature and thermally unstable defect types are present among them, a heat treatment (which may be also referred to as a recovery heat treatment) is further performed after applying the charged particle beams to annihilate the thermally unstable defects, or defect concentration is adjusted to enable acquiring a target value of the recombination lifetime.

For example, in Patent Document 3, there is a description that, to reduce a reverse recovery time of a diode, a heat treatment may be performed under heat treatment conditions to make crystal defects caused by electron beam irradiation remain, and a recombination lifetime of carriers may be set to approximately 0.1 to 1 (µsec). Further, in Patent Document 3, there is also a description that the heat treatment conditions in this case may be set so that a heat treatment temperature can be 350°C or more and less than 380°C and a heat treatment time can range from 0.5 hour to approximately 2 hours, for example.

Furthermore, in Patent Document 4, there is a description that, when a heat treatment temperature is 400°C or more, a lifetime of a wafer irradiated with protons is approximately 10 µs, which is desirable in terms of control over a diode forward voltage, the reverse recovery loss, and others.

The switching loss and steady loss in power devices have a tradeoff relationship, and hence strict control over the recombination lifetime is required to reduce overall loss.

Moreover, in breakdown voltage characteristics of power devices, since formation of an oxygen donor in a silicon substrate which causes a variation in resistivity of the silicon substrate becomes a problem, an FZ (Floating Zone) silicon substrate which hardly contains oxygen or a silicon substrate having oxygen concentration extremely lowered by an MCZ method provided by adding application of a magnetic field to a CZ method are often used in high-performance devices.

### CITATION LIST

### PATENT LITERATURE

Patent Document 1: Japanese Unexamined Patent Application Publication No. H11-135509
Patent Document 2: Japanese Unexamined Patent Application Publication No. 2000-200792
Patent Document 3: International Publication No. 2013/100155
Patent Document 4: International Publication No. 2007/055352
Patent Document 5: EP 1 811 065 A1
Patent Document 6: JP 2015/198166 A

### NON PATENT LITERATURE

Non Patent Document 1: Kiyoi et al., The 61st Japan Society of Applied Physics Spring Meeting, Meeting Proceedings, 19p-F9-14.
Non Patent Document 2: Minato et al., The 4th Workshop on Power Device Silicon and Related Semiconductor Materials, p. 77.
Non Patent Document 3: K. Takano et al., Proceeding of the 27th International Symposium on Power Semiconductor Devices & IC's, 2015, P. 129.
Non Patent Document 4: Sugiyama et al., Silicon Technology No. 87, P. 6.
Non Patent Document 5: Sugie et al., Silicon Technology No. 148. p. 11.
Non Patent Document 6: N. Inoue et al., Physica B 401-402 (2007), p. 477.
Non Patent Document 7: GRANT NICHOLAS E. ET AL: "Thermal activation and deactivation of grown-in defects limiting the lifetime of float-zone silicon", PHYSICA STATUS SOLIDI. RAPID RESEARCH LETTERS, vol. 10, no. 6, 1 June 2016 (2016-06-01), pages 443-447

### SUMMARY OF INVENTION

### TECHNICAL PROBLEM

However, even if conditions for particle beam irradiation or conditions for a heat treatment after the particle beam irradiation are equalized, there still remains a problem that device characteristics vary (Non Patent Document 1, Non Patent Document 2, and Non Patent Document 3). Since a variation in recombination lifetime directly affects a variation in device characteristics, improving the variation in recombination lifetime is a very important problem. In recent years in particular, with an improvement in performance of semiconductor devices, the recombination lifetime must be highly precisely controlled, and a variation thereof must be reduced as much as possible.

As a cause of the variation in recombination lifetime, any substance contained in silicon substrates themselves is suspicious as a factor, and an influence of impurities which are carbon or oxygen is concerned in particular.

Especially, in power devices in which the recombination lifetime of carriers is controlled by irradiating a silicon substrate with a particle beam of electrons or helium ions or the like, it has been pointed out that a very small amount of carbon which is 0.05 ppma or less adversely affects device characteristics (see Non Patent Document 4, Non Patent Document 5, and Non Patent Document 6). Thus, it has been considered that reducing the carbon contained in the silicon substrate as much as possible is important.

Furthermore, in Non Patent Document 1, it has been pointed out that, as a problem, wafer dependence occurs in the switching loss in some cases even if the same recombination lifetime control is carried out, only CiOi in primary defects (CsI, CiCs, or CiOi) produced by electron beam irradiation has the wafer dependence in activation energy, activation tends to escalate when oxygen concentration is high, and hence it has been considered that oxygen impurities become a factor of the wafer dependence (where Cs: substitutional carbon, Ci: interstitial carbon, Oi: interstitial oxygen, and I: interstitial silicon).

However, actually, whether the carbon or oxygen impurities are the main factor of the variation in recombination lifetime has not been cleared.

In view of the above-described problem, it is an object of the present invention to provide a method for controlling a recombination lifetime which can reduce a variation in recombination lifetime caused by a silicon substrate and highly precisely control the recombination lifetime in a power device manufacturing process where the recombination lifetime of carriers is controlled.

### SOLUTION TO PROBLEM

To solve the problem, the present invention provides a method for controlling a recombination lifetime which controls the recombination lifetime of carriers in a silicon substrate as defined in claim 1. The method for controlling a recombination lifetime which controls the recombination lifetime of carriers in a silicon substrate by performing:
a preparation step of preparing the silicon substrate in which the recombination lifetime of the carriers is to be controlled;
a particle beam irradiation step of irradiating the prepared silicon substrate with a particle beam; and
a heat treatment step of performing a heat treatment to the silicon substrate after the particle beam irradiation step,
the method including:
   a measurement step A1 of previously irradiating a plurality of test silicon substrates having different nitrogen concentrations with the particle beam before performing the preparation step, then carrying out a heat treatment, and measuring recombination lifetimes of carriers in the plurality of test silicon substrates; and
   a correlation acquisition step A2 of acquiring correlations between the measured recombination lifetimes and the nitrogen concentrations,
   the method being characterized in that nitrogen concentration of the silicon substrate prepared at the preparation step is adjusted on the basis of the acquired correlations in such a manner that the recombination lifetime of the silicon substrate after the heat treatment step for the silicon substrate reaches a target value.

In this manner, when the recombination lifetime is controlled by adjusting the nitrogen concentration of the silicon substrate in which the recombination lifetime is to be controlled on the basis of the correlations between the recombination lifetime and the nitrogen concentration of the heat-treated silicon substrate previously obtained from the test silicon substrates, a variation in recombination lifetime resulting from the silicon substrate itself can be reduced.

Moreover, according to the present invention, there is provided a method for controlling a recombination lifetime which controls the recombination lifetime of carriers in a silicon substrate as defined in claim 2. The method for controlling a recombination lifetime which controls the recombination lifetime of carriers in a silicon substrate by performing:
a preparation step of preparing the silicon substrate in which the recombination lifetime of the carriers is to be controlled;
a particle beam irradiation step of irradiating the prepared silicon substrate with a particle beam; and
a heat treatment step of performing a heat treatment to the silicon substrate after the particle beam irradiation step,
the method including:
   a measurement step B1 of previously irradiating a plurality of test silicon substrates having different nitrogen concentrations with the particle beam before performing the preparation step, then carrying out a heat treatment while changing a heat treatment time in accordance with each of the test silicon substrates having the respective nitrogen concentrations, and measuring a change in recombination lifetime of carriers in each of the plurality of test silicon substrates to a change in heat treatment time for each of the test silicon substrates having the respective nitrogen concentrations; and
   a correlation acquisition step B2 of acquiring a correlation between the measured change in recombination lifetime and the change in heat treatment time in accordance with each of the test silicon substrates having the respective nitrogen concentrations,
   wherein a heat treatment time at the heat treatment step for the silicon substrate is adjusted in correspondence with nitrogen concentration of the silicon substrate prepared at the preparation step on the basis of the acquired correlations in such a manner that the recombination lifetime of the silicon substrate after the heat treatment step for the silicon substrate reaches a target value.

In this manner, when the recombination lifetime is controlled by adjusting the heat treatment time of the heat treatment step in correspondence with the nitrogen concentration of the silicon substrate in which the recombination lifetime is to be controlled on the basis of the correlation between a change in recombination lifetime of the silicon substrate to the heat treatment time and the nitrogen concentration previously obtained from each test silicon substrate, a variation in recombination lifetime resulting from the silicon substrate itself can be further reduced.

The silicon substrate is manufactured from a nitrogen-added silicon single crystal grown by a floating zone method.

In an FZ silicon substrate manufactured by the floating zone method (which will be referred to as an FZ method hereinafter), to reduce crystal defects introduced at the time of crystal growth or improve wafer strength, it is often the case that nitrogen is added at the time of the crystal growth. The concentration of the nitrogen introduced into the grown single crystal can be controlled by adjustment of an atmospheric gas at the time of the crystal growth. In such an FZ silicon substrate, when the recombination lifetime is controlled by adjusting the nitrogen concentration of the silicon substrate in which the recombination lifetime is to be controlled on the basis of the correlation of the recombination lifetime and the nitrogen concentration of the silicon substrate after the heat treatment process, a variation in recombination lifetime resulting from the silicon substrate itself can be reduced. Further, when the recombination lifetime is controlled by adjusting the heat treatment time of the heat treatment step in correspondence with the nitrogen concentration of the silicon substrate in which the recombination lifetime is to be controlled on the basis of the correlation between a change in recombination lifetime of the silicon substrate to the heat treatment time and the nitrogen concentration, the variation in recombination lifetime resulting from the silicon substrate itself can be further reduced.

Furthermore, at this time, it is preferable for the silicon substrate prepared at the preparation step to be a silicon substrate having a variation in nitrogen concentration adjusted to fall within 10% to a target nitrogen concentration value.

In this manner, when the variation in nitrogen concentration is within 10%, the variation in recombination lifetime resulting from the silicon substrate itself can be reduced.

### ADVANTAGEOUS EFFECTS OF INVENTION

According to the method for controlling a recombination lifetime of the present invention, since the recombination lifetime can be highly precisely controlled by adjusting the nitrogen concentration of the silicon substrate, the variation in recombination lifetime resulting from the silicon substrate can be reduced. Furthermore, since the recombination lifetime can be highly precisely controlled by adjusting the heat treatment time after the particle beam irradiation in correspondence with the nitrogen concentration of the silicon substrate, the variation in recombination lifetime resulting from the silicon substrate can be further reduced. Furthermore, in case of controlling the recombination lifetime of the nitrogen-added FZ silicon substrate, since the recombination lifetime can be highly precisely controlled even if the nitrogen concentration is different, the present invention is preferred when the nitrogen-added FZ silicon substrate is used for a power device.

### BRIEF DESCRIPTION OF DRAWINGS

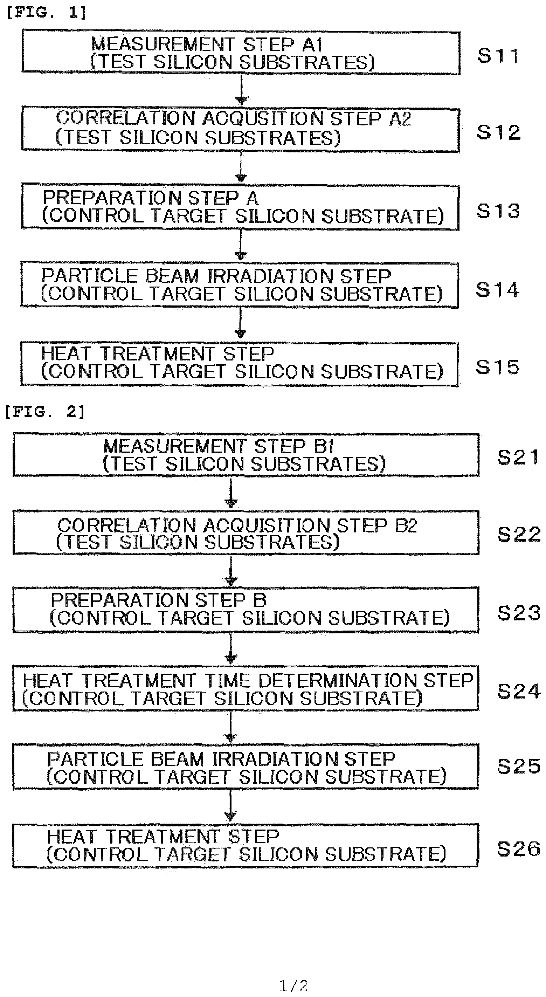

FIG. 1 is a view showing a method for controlling a recombination lifetime of a silicon substrate according to the present invention.
FIG. 2 is a view showing another mode of the method for controlling a recombination lifetime of a silicon substrate according to the present invention.

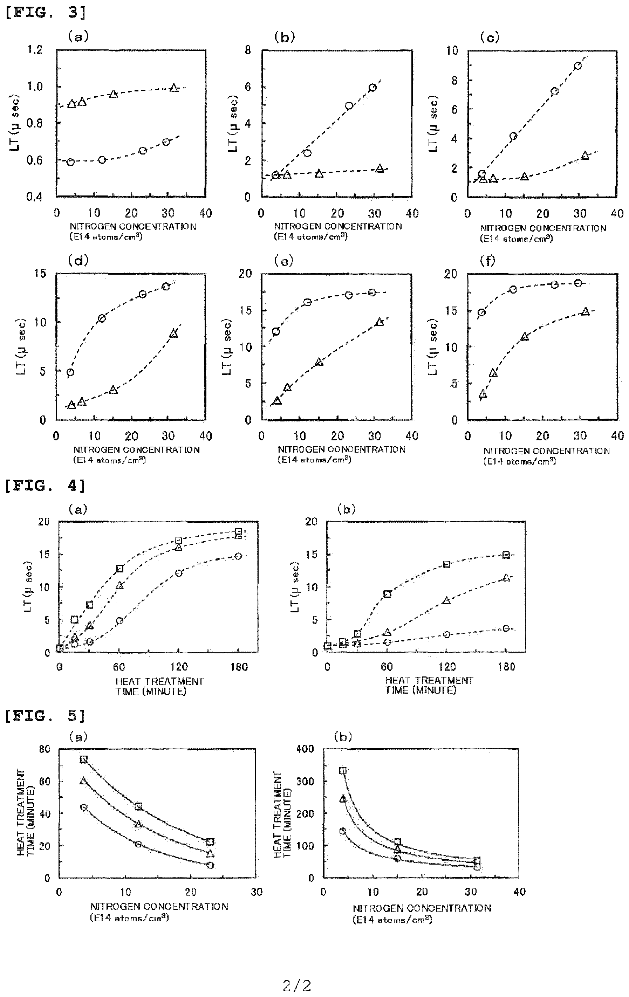

FIGS. 3 are graphs each showing a relationship between a recombination lifetime LT(t) and nitrogen concentration of a silicon substrate. As a heat treatment time, (a) represents 0 minute; (b), 15 minutes; (c), 30 minutes; (d), 60 minutes; (e), 120 minutes; and (f), 180 minutes. Symbol "○" represents a case where oxygen concentration is less than 0.1 ppma, and symbol "△" represents a case where the oxygen concentration is 0.2 to 0.3 ppma.
FIGS. 4 are graphs each showing a relationship between the recombination lifetime LT(t) and a heat treatment time t. (a) represents a case where the oxygen concentration is less than 0.1 ppma, and (b) represents a case where the oxygen concentration is 0.2 to 0.3 ppma. As regards nitrogen concentration, in (a), symbol "o" represents 3.6×10¹⁴ atoms/cm³, symbol "△" represents 1.2×10¹⁵ atoms/cm³, and symbol "□" represents 2.3×10¹⁵ atoms/cm³; and in (b), symbol "o" represents 3.9×10¹⁴ atoms/cm³, symbol "△" represents 1.5×10¹⁵ atoms/cm³, and symbol "□" represents 3.1×10¹⁵ atoms/cm³.
FIGS. 5 are graphs each showing a relationship between the nitrogen concentration of the silicon substrate and the heat treatment time to obtain a desired value of the recombination lifetime. (a) represents a case where the oxygen concentration is less than 0.1 ppma, and (b) represents a case where the oxygen concentration is 0.2 to 0.3 ppma. As to the recombination lifetime, in both (a) and (b), symbol "o" represents 3 µsec, symbol "△" represents 5 µsec, and symbol "□" represents 7 µsec.

### DESCRIPTION OF EMBODIMENTS

Embodiments of the present invention will now be described hereinafter in detail, but the present invention is not restricted thereto.

As described above, according to the conventional technology, a recombination lifetime of carriers is controlled by adjusting conditions for particle beam irradiation and conditions for a heat treatment after the particle beam irradiation and, in this case, there is a problem that the recombination lifetime varies due to any factor resulting from a silicon substrate.

The present inventor has conducted keen examinations, and found out that a recombination lifetime provided when a silicon substrate has been irradiated with a particle beam and subjected to a subsequent heat treatment varies even if carbon concentration and oxygen concentration which have been conventionally considered to be factors of the variation are almost unchanged and it is strongly dependent upon nitrogen concentration of the silicon substrate, thereby bringing the present invention to completion.

A method for controlling a recombination lifetime according to the present invention will now be described hereinafter with reference to FIG. 1.

First, a plurality of test silicon substrates are prepared. The plurality of test silicon substrates prepared here have different nitrogen concentrations. Further, conditions other than the nitrogen concentration can be the same conditions as those of a silicon substrate which is an actual target for controlling a recombination lifetime.

Furthermore, a method for preparing the test silicon substrates is not restricted in particular in the present invention. For example, silicon wafers can be sliced off from a silicon single crystal, a chemical etching treatment can be performed to the silicon wafers to eliminate slicing damage, and then mechano-chemical polishing can be performed to prepare the test silicon substrates. Moreover, the test silicon substrates each having an epitaxial layer grown in an epitaxial growth furnace may be prepared.

Subsequently, the plurality of test silicon substrates are irradiated with particle beams, then a heat treatment is performed, and a measurement step A1 to measure a recombination lifetime of carriers is carried out (S11 in FIG. 1). It is to be noted that a silicon substrate shown in parentheses in FIG. 1 represents a silicon substrate to be treated at each step.

Before the particle beam irradiation at this measurement step A1, an oxide film can be formed on a surface of each test silicon substrate.

The oxide film can be formed by a heat treatment in an oxidizing atmosphere. As conditions for the oxide film forming heat treatment, for example, a temperature can be set to 900 to 1100°C and a time can be set to 10 to 60 minutes. This oxide film has a role to suppress surface recombination at the time of measuring the recombination lifetime at the measurement step A1. When the surface recombination does not become a problem, this oxide film forming treatment can be omitted.

For the measurement of the recombination lifetime, for example, a microwave photoconductive decay method (Microwave Photoconductive Decay method: µ-PCD method) can be used. As measurement conditions in the µ-PCD method, generally-used conditions can suffice, and the measurement can be performed under, e.g., conditions described in a literature "JEIDA-53-1997 'Recombination Lifetime Measuring Method for Silicon Wafer based on Reflective Microwave Photoconductive Decay method'". As a measuring device, a commercially available device can be used.

At the measuring step A1, a defect which becomes a recombination center of carriers is produced by the particle beam irradiation, but it is desirable to match conditions for the particle beam irradiation with conditions used at a particle beam irradiation step (S14 in FIG. 1) for a control target silicon substrate in a manufacturing process of a target semiconductor device. For example, as the particle beam, irradiation of an electron beam can be performed with a dosage of 1×10¹³ to 1×10¹⁵/cm² and an acceleration voltage of 0.5 to 2 MeV.

At the measurement step A1, a heat treatment after the particle beam irradiation (which may be referred to as a recovery heat treatment hereinafter) is carried out, and it is desirable to match conditions for the recovery heat treatment with conditions used at a heat treatment step (S15 in FIG. 1) for the control target silicon substrate in the manufacturing process for the target semiconductor device. For example, a temperature can be set to 300 to 400°C, a time can be set to 10 to 60 minutes, and an atmosphere of nitrogen, oxygen, hydrogen, or the like can be used.

Subsequently, a correlation acquisition step A2 is performed (S12 in FIG. 1).

At the correlation acquisition step A2, associating the recombination lifetime measured at the measurement step A1 (S11 in FIG. 1) with the nitrogen concentration of each of the plurality of test silicon substrates enables acquiring a correlation between the recombination lifetime and the nitrogen concentration.

Then, on the basis of the correlation acquired as described above, the nitrogen concentration of the control target silicon substrate prepared at the preparation step is adjusted so that the recombination lifetime of the silicon substrate after the heat treatment step can reach a target value (S13 in FIG. 1).

A method for adjusting the nitrogen concentration of the prepared control target silicon substrate is not restricted in particular in the present invention. For example, a method for adjusting conditions for silicon single crystal growth can be used. For example, according to the FZ method, adjusting the nitrogen concentration in an atmospheric gas at the time of single crystal growth enables adjusting the nitrogen concentration in a silicon single crystal. According to the MCZ method provided by adding application of a magnetic field to the CZ method, the nitrogen concentration in the silicon single crystal can be adjusted with the use of an amount of a silicon nitride added into a crucible.

Then, a particle beam irradiation step is performed (S14 in FIG. 1).

As conditions for the particle beam irradiation performed here, it is desirable to adopt the same conditions as those in the measurement step A1 (S11 in FIG. 1). For example, irradiation of an electron beam can be performed with a dosage of 1×10¹³ to 1×10¹⁵/cm² and an acceleration voltage of 0.5 to 2 MeV.

Subsequently, a heat treatment step is carried out (S15 in FIG. 1).

As conditions for the heat treatment performed here, it is preferred to adopt the same conditions as those in the measurement step A1 (S11 in FIG. 1). For example, a temperature can be set to 300 to 400°C, a time can be set to 10 to 60 minutes, and an atmosphere of nitrogen, oxygen, hydrogen, or the like can be used.

According to the method for controlling a recombination lifetime of the present invention described above, the recombination lifetime can be highly precisely controlled, and a variation in recombination lifetime resulting from the silicon substrate can be reduced.

Additionally, in the present invention, the silicon substrate can be manufactured from a nitrogen-added silicon single crystal grown by the FZ method.

In the present invention, in the FZ silicon substrate, on the basis of the correlation between the recombination lifetime after the heat treatment step and the nitrogen concentration, the recombination lifetime can be controlled by adjusting the nitrogen concentration of the silicon substrate (the control target silicon substrate) in which the recombination lifetime is to be controlled, and a variation in recombination lifetime resulting from the silicon substrate itself can be decreased.

A description will now be given on another mode of the method for controlling a recombination lifetime according to the present invention with reference to FIG. 2.

First, a plurality of test silicon substrates are prepared. The plurality of test silicon substrates prepared here have different nitrogen concentrations. Further, conditions other than the nitrogen concentration can be the same conditions as those for a silicon substrate which is an actual target for controlling a recombination lifetime (a control target silicon substrate).

Further, a method for preparing the test silicon substrates is not restricted in particular in the present invention. For example, silicon wafers can be sliced off from a silicon single crystal, a chemical etching treatment can be performed to the silicon wafers to eliminate slicing damage, and then mechano-chemical polishing can be performed to prepare the test silicon substrates. Moreover, the test silicon substrates each having an epitaxial layer grown in an epitaxial growth furnace may be prepared.

Subsequently, the plurality of test silicon substrates are irradiated with particle beams, then a heat treatment is performed while changing a heat treatment time in accordance with each of the silicon substrates having respective nitrogen concentrations, and a measurement step B1 to measure a change in recombination lifetime of carriers to a change in heat treatment time for each of the test silicon substrates having the respective nitrogen concentrations is carried out (S21 in FIG. 2). It is to be noted that a silicon substrate shown in parentheses in FIG. 2 represents a silicon substrate to be treated at each step.

Before the particle beam irradiation at this measurement step B1, an oxide film can be formed on a surface of each test silicon substrate.

The oxide film can be formed by a heat treatment in an oxidizing atmosphere. As conditions for the oxide film forming heat treatment, for example, a temperature can be set to 900 to 1100°C and a time can be set to 10 to 60 minutes. This oxide film has a role to suppress surface recombination at the time of measuring the recombination lifetime. When the surface recombination does not become a problem, this oxide film forming treatment can be omitted.

For the measurement of the recombination lifetime, for example, a microwave photoconductive decay method (Microwave Photoconductive Decay method: µ-PCD method) can be used. As measurement conditions in the µ-PCD method, generally-used conditions can suffice, and the measurement can be performed under, e.g., conditions described in a literature "JEIDA-53-1997 'Recombination Lifetime Measuring Method for Silicon Wafer based on Reflective Microwave Photoconductive Decay method'". As a measuring device, a commercially available device can be used.

At the measuring step B1, a defect which becomes a recombination center of carriers is produced by the particle beam irradiation, but it is desirable to match conditions for the particle beam irradiation with conditions used at a particle beam irradiation step (S25 in FIG. 2) for a control target silicon substrate in a manufacturing process of a target semiconductor device. For example, as the particle beam, irradiation of an electron beam can be performed with a dosage of 1×10¹³ to 1×10¹⁵/cm² and an acceleration voltage of 0.5 to 2 MeV.

At the measurement step B1, the recovery heat treatment after the particle beam irradiation is carried out, and it is desirable to match a temperature and an atmosphere of the recovery heat treatment with conditions used at a heat treatment step (S26 in FIG. 2) for the control target silicon substrate in the manufacturing process for the target semiconductor device. For example, the temperature can be set to 300 to 400°C, and the atmosphere of nitrogen, oxygen, hydrogen, or the like can be used.

Further, here, to measure a change in recombination lifetime to a change in heat treatment time in accordance with each of the test silicon substrates having the respective nitrogen concentrations, the heat treatment time "t" is changed in a range of, e.g., 0<"t"≤180 minutes, and the plurality of test silicon substrates are subjected to the heat treatment.

Furthermore, a recombination lifetime [LT(t)] of each test silicon substrate after the recovery heat treatment at each heat treatment time "t" is measured, and a change in recombination lifetime of carriers in each of the plurality of test silicon substrates to the heat treatment time changed in accordance with each of the test silicon substrates having the respective nitride concentrations is measured from each of the measurement values.

Subsequently, a correlation acquisition step B2 is performed (S22 in FIG. 2).

At the correlation acquisition step B2, a correlation between the change in recombination lifetime measured in accordance with each of the test silicon substrates having the respective nitride concentrations at the measurement step B1 (S21 in FIG. 2) and the change in heat treatment time is acquired.

Then, a preparation step to prepare a silicon substrate in which a recombination lifetime is controlled (a control target silicon substrate) is carried out (S23 in FIG. 2).

Subsequently, on the basis of the correlation acquired at the correlation acquisition step B2 and the nitrogen concentration of the control target silicon substrate prepared at the preparation step (S23 in FIG. 2), a heat treatment time determination step to determine a heat treatment time of the heat treatment step is carried out (S24 in FIG. 2).

Then, a particle beam irradiation step is performed (S25 in FIG. 2).

As conditions for the particle beam irradiation performed here, it is preferred to adopt the same conditions as those of the measurement step B1 (S21 in FIG. 2). For example, irradiation of an electron beam can be performed with a dosage of 1×10¹³ to 1×10¹⁵/cm² and an acceleration voltage of 0.5 to 2 MeV.

Subsequently, a heat treatment step is carried out (S26 in FIG. 2).

As a temperature and an atmosphere of the heat treatment performed here, it is preferred to adopt the same conditions as those of the measurement step B1 (S21 in FIG. 2). For example, a temperature can be set to 300 to 400°C, and an atmosphere of nitrogen, oxygen, hydrogen, or the like can be used. As a time of the heat treatment, a time determined at the heat treatment time determination step (S24 in FIG. 2) is adopted.

According to such a method for controlling a recombination lifetime of the present invention as described above, the recombination lifetime can be highly precisely controlled, and a variation in recombination lifetime resulting from the silicon substrate can be suppressed.

Moreover, in the present invention, the silicon substrate can be manufactured from a nitrogen-added silicon single crystal grown by the FZ method.

In the present invention, in the FZ silicon substrate, the recombination lifetime can be precisely controlled by adjusting the heat treatment time of the heat treatment step in correspondence with the nitrogen concentration of the silicon substrate on the basis of the correlation between the change in recombination lifetime to the heat treatment time and the nitrogen concentration, and a variation in recombination lifetime resulting from the silicon substrate itself can be decreased.

In the present invention, a reason to use the above-describe method for controlling a lifetime of the silicon substrate to highly precisely control the lifetime and decrease a variation in lifetime resulting from the silicon substrate is based on the knowledge obtained by an experiment described below.

### (Experimental Example)

A plurality of silicon substrates having different nitrogen concentrations were prepared. A dopant type, dopant concentration, oxygen concentration, carbon concentration, nitrogen concentration, a diameter, and a crystal plane orientation of each of the plurality of silicon substrates are as described below.
The dopant type/concentration: phosphorous/6.2×10¹³ to 6.9×10¹³ atoms/cm³,
the oxygen concentration: <0.1 ppma (a silicon starting material is polycrystalline silicon), 0.2 to 0.3 ppma (a silicon starting material is single crystal silicon grown by the CZ method) (JEIDA),
the carbon concentration: <0.01 ppma (JEIDA),
the nitrogen concentration: 3.6×10¹⁴ to 3.1×10¹⁵ atoms/cm³,
the diameter: 200 mm, and
the crystal plane orientation: (100).

The silicon substrates each having oxygen concentration of less than 0.1 ppma are manufactured from the silicon single crystal grown by the FZ method using a normal polycrystalline silicon ingot as a starting material. Further, the silicon substrates each having oxygen concentration of 0.2 to 0.3 ppma are manufactured from the silicon single crystal grown by the FZ method using a silicon single crystal ingot grown by the CZ method as a starting material.

Then, an oxide film was formed on each of the prepared silicon substrates by an oxidation heat treatment. A heat treatment temperature was 1000°C, a time was 60 minutes, and an atmosphere was oxygen.

Subsequently, each silicon substrate after the oxidation heat treatment was irradiated with an electron beam. At this time, an irradiation dosage of the electron beam was 1×10¹⁵/cm², and an acceleration voltage of the electron beam was 750 kV.

Then, each silicon substrate which has been irradiated with the electron beam was subjected to a recovery heat treatment. A temperature of the recovery heat treatment was 360°C, an atmosphere was nitrogen, and a time "t" was allocated in the range of 0 to 180 minutes. Thereafter, a recombination lifetime [LT(t)] was measured by the µ-PCD method.

FIGS. 3 show relationships between the recombination lifetime LT(t) and the nitrogen concentration. The heat treatment time is 0 minute in FIG. 3(a), 15 minutes in FIG. 3(b), 30 minutes in FIG. 3(c), 60 minutes in FIG. 3(d), 120 minutes in FIG. 3(e), and 180 minutes in FIG. 3(f). A difference in symbol in FIGS. 3 represents a difference in oxygen concentration, and symbol "o" indicates a case where the oxygen concentration is less than 0.1 ppma whilst symbol "△" indicates a case where the same is 0.2 to 0.3 ppma.

It can be understood from FIGS. 3 that nitrogen concentration dependence of LT(t) is weak when the heat treatment time is 0 minute [FIG. 3(a)], i.e., when the heat treatment is not performed after the electron beam irradiation, but performing the heat treatment increases the nitrogen concentration dependence, and LT(t) becomes longer as the nitrogen concentration rises. Furthermore, the nitrogen concentration dependence of LT(t) differs depending on the oxygen concentration of the silicon substrate. When the oxygen concentration is less than 0.1 ppma, the nitrogen concentration dependence becomes strong with a short heat treatment time of 15 to 60 minutes [FIG. 3(b) to FIG. 3(d)], and LT(t) tends to be saturated in a high nitrogen concentration domain with a longer heat treatment time [FIG. 3(e), FIG. 3(f)]. Further, when the oxygen concentration is 0.2 to 0.3 ppma, the nitrogen concentration dependence is weak with a relatively short heat treatment time of 15 to 30 minutes [FIG. 3(b), FIG. 3(c)], but the nitrogen concentration dependence becomes strong with a longer heat treatment time [FIG. 3(d) to FIG. 3(f)].

The oxygen concentration of the FZ silicon substrate differs depending on which one of polycrystalline silicon or single crystal silicon grown by the CZ method is adopted as a silicon starting material used in crystal manufacturing, but a variation in oxygen concentration can be reduced if a manufacturing method of the silicon starting material is the same.

Thus, it can be understood that adjusting the nitrogen concentration enables controlling LT(t) in the FZ silicon substrates using either one of these starting materials.

Next, FIGS. 4 show relationships between the recombination lifetime LT(t) and the heat treatment time "t". FIG. 4(a) shows a case where the oxygen concentration is less than 0.1 ppma, and FIG. 4(b) shows a case where the oxygen concentration is 0.2 to 0.3 ppma. Differences in symbol in FIGS. 4 represent differences in nitrogen concentration, FIG. 4(a) shows a case where symbol "o" is 3.6×10¹⁴ atoms/cm³, symbol "△" is 1.2×10¹⁵ atoms/cm³, and symbol "□" is 2.3×10¹⁵ atoms/cm³, and FIG. 4(b) shows a case where symbol "○" is 3.9×10¹⁴ atoms/cm³, symbol "△" is 1.5×10¹⁵ atoms/cm³, and symbol "□" is 3.1×10¹⁵ atoms/cm³.

It can be understood from FIGS. 4 that the recombination lifetime LT(t) becomes longer along with the heat treatment time "t" but the recombination lifetime LT(t) becomes longer in a shorter heat treatment time as the nitrogen concentration becomes higher.

Next, FIGS. 5 show relationships between the nitrogen concentration and the heat treatment time to obtain a target value of the recombination lifetime. FIG. 5(a) shows a case where the oxygen concentration is less than 0.1 ppma, and FIG. 5(b) shows a case where the oxygen concentration is 0.2 to 0.3 ppma. Differences in symbol in FIGS. 5 represent differences in target value of the recombination lifetime, and both FIG. 5(a) and FIG. 5(b) show cases where symbol "o" is 3 µsec, symbol "△" is 5 µsec, and symbol "□" is 7 µsec.

Thus, the recombination lifetime can reach the target value by adjusting the heat treatment time in correspondence with the nitrogen concentration of the silicon substrate in which the recombination lifetime is to be controlled.

As described above, when the recombination lifetime is controlled by adjusting the nitrogen concentration of the silicon substrate in which the recombination lifetime is to be controlled in such a manner that the recombination lifetime when the electron beam irradiation and the subsequent heat treatment have been performed can reach the target value, a variation in recombination lifetime resulting from the silicon substrate itself can be reduced. Furthermore, when the recombination lifetime is controlled by adjusting the heat treatment time in correspondence with the nitrogen concentration of the silicon substrate in which the recombination lifetime is to be controlled in such a manner that the recombination lifetime when the electron beam irradiation and the subsequent heat treatment have been performed can reach the target value, a variation in recombination lifetime resulting from the silicon substrate itself can be further reduced. Moreover, when a variation in nitrogen concentration is decreased, a variation in recombination lifetime can be reduced.

A reason why the recombination lifetime when the electron beam irradiation and the subsequent heat treatment have been performed is dependent upon the nitrogen concentration as described above can be considered as follows.

When the silicon substrate is irradiated with a particle beam having high energy, a silicon atom at a lattice position is flicked out, and interstitial silicon (which will be referred to as I hereinafter) and a vacancy (which will be referred to as V hereinafter) which is an empty shell thereof are produced. The excessively produced I or V is unstable when it is alone, they recombine (V+I→O), clustering of Is or clustering of Vs occurs, or they react with a light element impurity to form a composite. Additionally, the cluster of I or V or the composite of I or V and the light element impurity forms a deep level in a bandgap of silicon, functions as a recombination center of carriers, and decreases the recombination lifetime.

It has been known that, as a defect concerning the vacancy V, V and a substitutional phosphorous Ps react to form VP (V+Ps-VP). Further, V and the interstitial oxygen Oi react to form VO (V+Oi→VO), an V and VO react to form V₂O (V+VO→V₂O) in some cases. Furthermore, a pair of V react to form VV (V+V→VV). When the nitrogen is present, V and N react to form VN (V+N→VN). Since reactions of V and P, O, or N compete against each other, if VN is apt to be formed when the nitrogen concentration is high, there is a possibility that other composites to which V relates are hardly formed.

On the other hand, it has been known that, as defects to which the interstitial silicon I relates, I and substitutional boron Bs react to form interstitial boron Bi (I+Bs→Bi), and Bi and Oi react to form BiOi (Bi+Oi→BiOi). Furthermore, when the carbon is present, I and the substitutional carbon Cs react to form interstitial carbon Ci (I+Cs→Ci), and Ci and Oi or Ci and Cs react to form CiOi or CiCs (Ci+Oi→CiOi, Ci+Cs->CiCs). Moreover, I also reacts with other I to form an I cluster (I+I+...->In). When the nitrogen is present, a reaction of V and N suppresses the recombination of V and I, and hence there is a possibility that a composite to which I relates is apt to be formed.

Since the reaction of I or V and a light element impurity is dependent on each absolute concentration and a concentration balance, it is very complicated, and estimating which composite becomes dominant is difficult. Additionally, when the heat treatment has been performed, annihilation or morphological transformation of the composites occurs, resulting in further complexity.

As illustrated with the above experimental example, when the nitrogen concentration of the silicon substrate increases, since thermally unstable composites are apt to be formed by the irradiation of the particle beam having high energy, it can be considered that the composites are readily annihilated by the subsequent heat treatment and the recombination lifetime after the heat treatment increases.

### EXAMPLE

The present invention will now be more specifically described hereinafter with reference to examples and comparative examples, but the present invention is not restricted these examples.

### (Example 1)

A recombination lifetime of each silicon substrate was controlled by such a method for controlling a recombination lifetime of the present invention as shown in FIG. 1. At this time, an object was to control the recombination lifetime to approximately 3 µsec.

First, at the measurement step A1, a plurality of test silicon substrates having different nitrogen concentrations were irradiated with a particle beam and then subjected to a heat treatment, and a recombination lifetime of carriers in each of the plurality of test silicon substrates was measured. Each of the test silicon substrates was manufactured from a silicon single crystal grown by the FZ method using polycrystalline silicon as a silicon starting material, and its oxygen concentration was set to 0.1 ppma or less.

An irradiation dosage of the electron beam at this moment was set to 1×10¹⁵/cm², and an acceleration voltage of the electron beam was set to 750 kV. Moreover, at this moment, a temperature of the heat treatment was set to 360°C, a time of the same was 30 minutes, an atmosphere of the same was nitrogen.

Then, at the correlation acquisition step A2, correlations between the recombination lifetimes and nitrogen concentrations in the plurality of test silicon substrates were acquired (symbols "o" in FIG. 3(c)).

Subsequently, on the basis of the correlations, nitrogen concentration of a silicon substrate prepared at the preparation step A was adjusted in such a manner that the recombination lifetime of the silicon substrate after the heat treatment step can reach a target value (approximately 3 µsec). At this moment, the prepared silicon substrate was manufactured from a silicon single crystal grown by the FZ method using polycrystalline silicon as a silicon starting material and has the oxygen concentration adjusted to 0.1 ppma or less and the nitrogen concentration adjusted to 8.0×10¹⁴ atoms/cm³.

Then, an oxide film was formed on the prepared silicon substrate by an oxidation heat treatment. A heat treatment temperature was set to 1000°C, a time was set to 60 minutes, and an atmosphere was oxygen.

Thereafter, at the particle beam irradiation step, the silicon substrate was irradiated with the electron beam. An irradiation dosage of the electron beam was set to 1×10¹⁵/cm², and an acceleration voltage of the electron beam was set to 750 kV.

Subsequently, at the heat treatment step, a recovery heat treatment was performed to the silicon substrate which has been irradiated with the electron beam. A temperature of the recovery heat treatment was set to 360°C, an atmosphere of the same was nitrogen, and a time of the same was 30 minutes.

As a result of measuring the recombination lifetime after the recovery heat treatment by the µ-PCD method, the recombination lifetime of the silicon substrate was 2.9 µsec.

As described above, in Example 1, it has been confirmed that the target value of the recombination lifetime was achieved by adjusting the nitrogen concentration of the silicon substrate.

Additionally, five FZ silicon substrates each having the nitrogen concentration adjusted in the range of 7.2×10¹⁴ to 8.8×10¹⁴ atoms/cm³ on the basis of the correlations obtained above were prepared, the oxidation heat treatment, the electron beam irradiation, and the recovery heat treatment were performed under the same conditions as described above, and then recombination lifetimes were measured by the µ-PCD method. Consequently, it has been confirmed that the recombination lifetimes were 2.9 µsec, 2.9 µsec, 3.2 µsec, 2.7 µsec, and 3.0 µsec and a variation in recombination lifetime resulting from the silicon substrates themselves was greatly suppressed small.

### (Comparative Example 1)

A recombination lifetime of a silicon substrate was controlled under the same conditions as those in Example 1 except that correlations between recombination lifetimes and nitrogen concentrations were not obtained with the use of test silicon substrates and nitrogen concentration of a prepared silicon substrate was not adjusted on the basis of the correlations. At this moment, the nitrogen concentration is 1.5×10¹⁵ atoms/cm³, an oxide film was formed on an FZ silicon substrate using polycrystalline silicon as a silicon starting material and having oxygen concentration which is less than 0.1 ppma under the same conditions as those in Example 1, and a recovery heat treatment was performed after electron beam irradiation.

Subsequently, a recombination lifetime after the recovery heat treatment was measured under the same conditions as those in Example 1, and a result was 5.0 µsec.

As described above, in Comparative Example 1, it has been confirmed that even though the oxide film forming heat treatment conditions, the electron beam irradiation conditions, and the recovery heat treatment conditions were the same as the conditions in Example 1, the recombination lifetime of the silicon substrate became a value greatly deviating from 3 µsec which is the target value.

Further, five FZ silicon substrates having different nitrogen concentrations were prepared in a random manner, the oxidation heat treatment, the electron beam irradiation, and the recovery heat treatment were performed under the same conditions as described above, then recombination lifetimes were measured by the µ-PCD method, recombination lifetime results were 1.6 µsec, 4.2 µsec, 7.0 µsec, 8.2 µsec, and 8.9 µsec, and it has been confirmed that a variation in recombination lifetime resulting from the silicon substrates themselves become considerably large as compared with Example 1.

### (Example 2)

A recombination lifetime of a silicon substrate was controlled by such a method for controlling a recombination lifetime of the present invention as shown in FIG. 2. At this moment, it was an object to control the recombination lifetime to approximately 7 µsec.

First, at the measurement step B1, after irradiating a plurality of test silicon substrates having different nitrogen concentrations with a particle beam, a heat treatment was carried out while changing a heat treatment time, and changes in recombination lifetime of carriers in the plurality of test silicon substrates to changes in heat treatment time were measured. The test silicon substrates were manufactured from a silicon single crystal grown by the FZ method using a single crystal grown by the CZ method as a silicon starting material, and their oxygen concentrations were set to 0.3 ppma.

An irradiation does of the electron beam at this moment was set to 1×10¹⁵/cm², and an acceleration voltage of the electron beam was set to 750 kV. Furthermore, at this moment, a temperature of the heat treatment was set to 360°C, an atmosphere was nitrogen, and the heat treatment time was changed in the range of 0 to 180 minutes.

Then, at the correlation acquisition step B2, using the results at the measurement step B1, each correlation between a change in recombination lifetime measured in accordance with each of the test silicon substrates having the respective nitrogen concentrations and a change in heat treatment time for each of the test silicon substrates having the respective nitrogen concentrations was acquired (FIG. 4(b)).

Subsequently, at the preparation step B, a silicon substrate in which the recombination lifetime is to be controlled was prepared. This silicon substrate was manufactured from a silicon single crystal grown by the FZ method using a single crystal grown by the CZ method as a silicon starting material, and had oxygen concentration of 0.3 ppma and nitrogen concentration of 1.5×10¹⁵ atoms/cm³.

Then, at the heat treatment time determination step, on the basis of the correlation, the heat treatment time at the heat treatment step when the nitrogen concentration of the silicon substrate is 1.5×10¹⁵ atoms/cm³ was determined to be 110 minutes in such a manner that the recombination lifetime after the heat treatment step can reach the target value (approximately 7 µsec) (symbols "△" in FIG. 4(b), symbols "□" in FIG. 5(b)).

Then, an oxide film was formed on the prepared silicon substrate by an oxidation heat treatment. A heat treatment temperature was set to 1000°C, a time was set to 60 minutes, and an atmosphere was oxygen.

Thereafter, at the particle irradiation step, the silicon substrate was irradiated with an electron beam. An irradiation dosage of the electron beam was set to 1×10¹⁵/cm², and an acceleration voltage of the electron beam was set to 750 kV.

Subsequently, at the heat treatment step, a recovery heat treatment was performed to the silicon substrate which has been irradiated with the electron beam. A temperature of the recovery heat treatment was set to 360°C, an atmosphere of the same was nitrogen, and a time of the same was set to 110 minutes.

The recombination lifetime after the recovery heat treatment was measured by the µ-PCD method, and the resulting recombination lifetime of the silicon substrate was 6.8 µsec.

As described above, in Example 2, it has been confirmed that adjusting the heat treatment time at the heat treatment step enables achieving the target value of the recombination lifetime.

### (Comparative Example 2)

A recombination lifetime of a silicon substrate was controlled under the same conditions as those in Example 2 except that a correlation between a change in recombination lifetime to a recovery heat treatment time and nitrogen concentration was not obtained with the use of test silicon substrates and the recovery heat treatment time was not adjusted on the basis of the correlation.

At this moment, an oxide film was formed on an FZ silicon substrate having nitrogen concentration of 1.5×10¹⁵ atoms/cm³ and oxygen concentration of 0.3 ppma under the same conditions as those in Example 2, and a recovery heat treatment was performed after electron beam irradiation. A recovery heat treatment time was set to 30 minutes.

Subsequently, a recombination lifetime after the recovery heat treatment was measured by the µ-PCD method under the same conditions as those in Example 2, and a result was 1.5 µsec.

As described above, in Comparative Example 2, it has been confirmed that even though the nitrogen concentration of the silicon substrate, the oxide film forming heat treatment conditions, and the electron beam irradiation conditions were the same as those in Example 2, the recombination lifetime of the silicon substrate becomes a value greatly deviating from 7 µsec which is a target value.

It is to be noted that the present invention is not restricted to the foregoing embodiment. The foregoing embodiment is an illustrative example.

## Claims

1. A method for controlling a recombination lifetime which controls the recombination lifetime of carriers in a silicon substrate by performing:
a preparation step of preparing the silicon substrate in which the recombination lifetime of the carriers is to be controlled, wherein the silicon substrate is manufactured from a nitrogen-added silicon single crystal grown by a floating zone method;
a particle beam irradiation step of irradiating the prepared silicon substrate with a particle beam; and
a heat treatment step of performing a heat treatment to the silicon substrate after the particle beam irradiation step,
the method comprising:
a measurement step A1 of previously irradiating a plurality of test silicon substrates having different nitrogen concentrations with the particle beam before performing the preparation step, then carrying out a heat treatment, and measuring recombination lifetimes of carriers in the plurality of test silicon substrates; and
a correlation acquisition step A2 of acquiring correlations between the measured recombination lifetimes and the nitrogen concentrations,
wherein nitrogen concentration of the silicon substrate prepared at the preparation step is adjusted on the basis of the acquired correlations in such a manner that the recombination lifetime of the silicon substrate after the heat treatment step for the silicon substrate reaches a target value.

2. A method for controlling a recombination lifetime which controls the recombination lifetime of carriers in a silicon substrate by performing:
a preparation step of preparing the silicon substrate in which the recombination lifetime of the carriers is to be controlled, wherein the silicon substrate is manufactured from a nitrogen-added silicon single crystal grown by a floating zone method;
a particle beam irradiation step of irradiating the prepared silicon substrate with a particle beam; and
a heat treatment step of performing a heat treatment to the silicon substrate after the particle beam irradiation step,
the method comprising:
a measurement step B1 of previously irradiating a plurality of test silicon substrates having different nitrogen concentrations with the particle beam before performing the preparation step, then carrying out a heat treatment while changing a heat treatment time in accordance with each of the test silicon substrates having the respective nitrogen concentrations, and measuring a change in recombination lifetime of carriers in each of the plurality of test silicon substrates to a change in heat treatment time for each of the test silicon substrates having the respective nitrogen concentrations; and
a correlation acquisition step B2 of acquiring a correlation between the measured change in recombination lifetime and the change in heat treatment time in accordance with each of the test silicon substrates having the respective nitrogen concentrations,
wherein a heat treatment time at the heat treatment step for the silicon substrate is adjusted in correspondence with nitrogen concentration of the silicon substrate prepared at the preparation step on the basis of the acquired correlations in such a manner that the recombination lifetime of the silicon substrate after the heat treatment step for the silicon substrate reaches a target value.

3. The method for controlling a recombination lifetime according to claim 1 or 2, wherein, at the preparation step, a silicon substrate having a variation in nitrogen concentration adjusted to fall within 10% to a target nitrogen concentration value is used.

## Patentansprüche

1. Verfahren zur Steuerung einer Rekombinationslebensdauer, das die Rekombinationslebensdauer von Trägern in einem Siliziumsubstrat steuert, indem durchgeführt wird:
ein Vorbereitungsschritt zum Vorbereiten des Siliziumsubstrats, in dem die Rekombinationslebensdauer der Träger gesteuert werden soll, wobei das Siliziumsubstrat aus einem mit Stickstoff dotierten Silizium-Einkristall hergestellt wird, der nach einem Floating-Zone-Verfahren gezüchtet wurde;
ein Teilchenstrahl-Bestrahlungsschritt zum Bestrahlen des vorbereiteten Siliziumsubstrats mit einem Teilchenstrahl; und
ein Wärmebehandlungsschritt zum Durchführen einer Wärmebehandlung an dem Siliziumsubstrat nach dem Teilchenstrahlbestrahlungsschritt,
wobei das Verfahren umfasst:
einen Messschritt A1 zum Vorabbestrahlen einer Mehrzahl von Testsiliziumsubstraten mit unterschiedlichen Stickstoffkonzentrationen mit dem Teilchenstrahl vor der Durchführung des Vorbereitungsschritts, anschließendes Durchführen einer Wärmebehandlung und Messen von Rekombinationslebenszeiten der Träger in der Mehrzahl von Testsiliziumsubstraten; und
einen Korrelationserfassungsschritt A2 zum Erfassen von Korrelationen zwischen den gemessenen Rekombinationslebensdauern und den Stickstoffkonzentrationen,
wobei die Stickstoffkonzentration des im Vorbereitungsschritt vorbereiteten Siliziumsubstrats auf der Grundlage der erfassten Korrelationen so eingestellt wird, dass die Rekombinationslebensdauer des Siliziumsubstrats nach dem Wärmebehandlungsschritt für das Siliziumsubstrat einen Zielwert erreicht.

2. Verfahren zur Steuerung einer Rekombinationslebensdauer, das die Rekombinationslebensdauer von Trägern in einem Siliziumsubstrat steuert, indem durchgeführt wird:
ein Vorbereitungsschritt zum Vorbereiten des Siliziumsubstrats, in dem die Rekombinationslebensdauer der Träger gesteuert werden soll, wobei das Siliziumsubstrat aus einem mit Stickstoff dotierten Silizium-Einkristall hergestellt wird, der nach einem Floating-Zone-Verfahren gezüchtet wurde;
ein Teilchenstrahl-Bestrahlungsschritt zum Bestrahlen des vorbereiteten Siliziumsubstrats mit einem Teilchenstrahl; und
ein Wärmebehandlungsschritt zum Durchführen einer Wärmebehandlung an dem Siliziumsubstrat nach dem Teilchenstrahlbestrahlungsschritt,
wobei das Verfahren umfasst:
einen Messschritt B1 zum Vorabbestrahlen einer Mehrzahl von Testsiliziumsubstraten mit unterschiedlichen Stickstoffkonzentrationen mit dem Teilchenstrahl vor der Durchführung des Vorbereitungsschritts, anschließendes Durchführen einer Wärmebehandlung, während eine Wärmebehandlungszeit entsprechend jedem der Testsiliziumsubstrate mit den jeweiligen Stickstoffkonzentrationen variiert wird, und Messen einer Änderung der Rekombinationslebensdauer der Träger in jedem der Mehrzahl von Testsiliziumsubstraten in Abhängigkeit von einer Änderung der Wärmebehandlungszeit für jedes der Testsiliziumsubstrate mit den jeweiligen Stickstoffkonzentrationen; und
einen Korrelationserfassungsschritt B2 zum Erfassen einer Korrelation zwischen der gemessenen Änderung der Rekombinationslebensdauer und der Änderung der Wärmebehandlungszeit entsprechend jedem der Testsiliziumsubstrate mit den jeweiligen Stickstoffkonzentrationen,
wobei eine Wärmebehandlungszeit in dem Wärmebehandlungsschritt für das Siliziumsubstrat in Übereinstimmung mit der Stickstoffkonzentration des im Vorbereitungsschritt hergestellten Siliziumsubstrats auf der Grundlage der erfassten Korrelationen so eingestellt wird, dass die Rekombinationslebensdauer des Siliziumsubstrats nach dem Wärmebehandlungsschritt für das Siliziumsubstrat einen Zielwert erreicht.

3. Verfahren zur Steuerung einer Rekombinationslebensdauer gemäß Anspruch 1 oder 2, wobei in dem Vorbereitungsschritt ein Siliziumsubstrat verwendet wird, dessen Variation der Stickstoffkonzentration so eingestellt wird, dass sie innerhalb von 10 % um einen Zielwert für die Stickstoffkonzentration liegt.

## Revendications

1. Procédé de commande de la durée de vie de recombinaison, qui commande la durée de vie de recombinaison des porteurs dans un substrat de silicium en effectuant:
une étape de préparation consistant à préparer le substrat de silicium dans lequel la durée de vie de recombinaison des porteurs doit être commandée, dans lequel le substrat de silicium est fabriqué à partir d'un monocristal de silicium enrichi en azote, obtenu par la méthode de zone flottante;
une étape d'exposition à un faisceau de particules consistant à exposer le substrat de silicium préparé à un faisceau de particules; et
une étape de traitement thermique consistant à soumettre le substrat de silicium à un traitement thermique après l'étape d'exposition à un faisceau de particules,
le procédé comprenant:
une étape A1 de mesure consistant à soumettre au préalable, au faisceau de particules, une pluralité de substrats de silicium d'essai présentant différentes concentrations en azote avant d'effectuer l'étape de préparation, puis à réaliser un traitement thermique, et à mesurer les durées de vie de recombinaison des porteurs dans la pluralité de substrats de silicium d'essai; et
une étape A2 d'acquisition de corrélation consistant à acquérir une corrélation entre les durées de vie de recombinaison mesurées et les concentrations d'azote,
dans lequel la concentration en azote du substrat de silicium préparé à l'étape de préparation est ajustée sur la base des corrélations obtenues, de telle sorte que la durée de vie de recombinaison du substrat de silicium, après l'étape de traitement thermique du substrat de silicium, atteigne une valeur cible.

2. Procédé de commande de la durée de vie de recombinaison, qui commande la durée de vie de recombinaison des porteurs dans un substrat de silicium en effectuant:
une étape de préparation consistant à préparer le substrat de silicium dans lequel la durée de vie de recombinaison des porteurs doit être commandée, dans lequel le substrat de silicium est fabriqué à partir d'un monocristal de silicium enrichi en azote, obtenu par la méthode de zone flottante;
une étape d'exposition à un faisceau de particules consistant à exposer le substrat de silicium préparé à un faisceau de particules; et
une étape de traitement thermique consistant à soumettre le substrat de silicium à un traitement thermique après l'étape d'exposition à un faisceau de particules,
le procédé comprenant:
une étape B1 de mesure consistant à soumettre au préalable, au faisceau de particules, une pluralité de substrats de silicium d'essai présentant différentes concentrations en azote avant d'effectuer l'étape de préparation, puis à réaliser un traitement thermique tout en modifiant la durée du traitement thermique en fonction de chacun des substrats de silicium d'essai présentant les concentrations en azote respectives, et à mesurer la variation de la durée de vie de recombinaison des porteurs dans chaque substrat de la pluralité des substrats de silicium d'essai en fonction de la variation de la durée du traitement thermique pour chacun des substrats de silicium d'essai présentant les concentrations en azote respectives; et
une étape B2 d'acquisition de corrélation consistant à acquérir une corrélation entre la variation mesurée de la durée de vie de recombinaison et la variation de la durée du traitement thermique, en fonction de chacun des substrats de silicium d'essai présentant les concentrations en azote respectives,
dans lequel la durée du traitement thermique à l'étape de traitement thermique du substrat en silicium est ajustée en fonction de la concentration en azote du substrat en silicium préparé à l'étape de préparation, sur la base des corrélations acquises, de telle sorte que la durée de vie de combinaison du substrat de silicium après l'étape de traitement thermique atteigne une valeur cible.

3. Procédé de commande d'une durée de vie de recombinaison selon la revendication 1 ou 2, dans lequel, à l'étape de préparation, on utilise un substrat de silicium dont la variation de concentration en azote est ajustée de manière à s'inscrire dans une plage de 10 % par rapport à une valeur cible de concentration en azote.
